# EUROPEAN PATENT SPECIFICATION

(11) **EP 1 026 828 B1**
(45) Date of publication and mention of the grant of the patent: **12.10.2005**
(21) Application number: 00101741.7
(22) Date of filing: 28.01.2000
(51) Int. Cl.: H03M 11/10

(54) **Generating a control signal for an electrical device with the aid of keys**
Erzeugung eines Steuersignals für eine elektrische Vorrichtung mit Hilfe von Tasten
Génération d'un signal de commande pour un dispositif électrique à l'aide de touches

(30) Priority: 04.02.1999 FI 990214
(43) Date of publication of application: 09.08.2000
(73) Proprietor: Nokia Corporation, 02150 Espoo (FI)
(72) Inventor: Santahuhta, Raimo, 21420 Lieto (FI)
(74) Representative: Brax, Matti Juhani

(56) References cited:
- US-A- 5 258 748
- PATENT ABSTRACTS OF JAPAN vol. 1996, no. 05, 31 May 1996 (1996-05-31) & JP 08 006692 A (HITACHI VLSI ENG CORP), 12 January 1996 (1996-01-12)
- PATENT ABSTRACTS OF JAPAN vol. 017, no. 095 (P-1493), 25 February 1993 (1993-02-25) & JP 04 290111 A (FUJITSU LTD), 14 October 1992 (1992-10-14)
- PATENT ABSTRACTS OF JAPAN vol. 014, no. 401 (E-0971), 30 August 1990 (1990-08-30) & JP 02 151128 A (HITACHI LTD;OTHERS: 01), 11 June 1990 (1990-06-11)
- Quick reference guide to Motorola phone, 'Montecarlo', 30.06.1998 retrieved on 21.04.2004 from www.strategicpartners.co.uk/Documents/monte carlo.pdf

## Description

The invention relates generally to the control of the operation of electrical devices. Particularly the invention relates to generating a control signal with the same keys which normally are used for generating input signals.

The signals supplied by a user to an electrical device can be divided into two groups: the input signals related to the normal operation of the device; and the control signals controlling the operation of the whole device or the operation of such parts of the device, which are not related to the normal operation. The input signals are generally signals of the information type which are directed to the device: in the device they are directed for instance to a microprocessor which interprets them according to the currently running program. The control signals are generally of the instruction type and have a higher priority than the input signals. They must be generated and supplied to their destination also in exceptional situations where the device does not operate in the designed manner, for instance in a situation where the microprocessors controlling the operation of the device can not return to the normal operation, or where they are infinitely repeating a command. In the following the term "control signal" refers to a signal, with the aid of which the aim is to immediately generate a desired response, irrespective of in which state the device or the microprocessors and other intelligent components related to the normal operation are.

Electrical devices generally have a keyboard or a set of keys with which the user generates input signals, for instance selects the number of the channel to be viewed in a television set. Pressing a key generally results in a voltage level change, and this change is interpreted as an input signal or as a part of an input signal. Each key can for instance be connected to an input port of a microprocessor, and sequential voltage level changes at the input port form an input signal which the microprocessor reads and which has an impact on the operation of the device, in a manner determined by the microprocessor's program. It is not possible to generate control signals and read them in the same way as the input signals, because the control signals must by-pass the input signals and generate an operation in any situation. Otherwise for instance a microprocessor which indefinitely repeats a command would never have time to observe a received control signal and to react on this signal.

Therefore prior art devices often contain separate control keys which either directly provide the desired function (for instance a power switch) or generate the desired control signal, which then triggers the desired function (for instance resetting the device). These control keys are accompanied by electrical circuitry which often is completely separated from the circuitry related to the input signals. In the prior art the separate control keys are such that they are accessible when required, but their unintentional use should be unlikely. The control keys can be placed for instance under a sliding lid, or at the backside of a larger device, and they can have forms and colours differing from those of the keys used to generate the input signals. A separate key will generally represent each control signal or control function.

Particularly in the design of electrical terminal devices the aim is often to minimise the number of keys in the device for reasons related to both the size and the appearance of the device. Thus the separate control keys are not a good solution, and often it is not even possible to realise such a solution: for instance it may be necessary to leave out the power switch due to lacking space in the device, and in fault situations the user must reset the device by taking out the electrical plug from the outlet and then reinsert it. Moreover, the operating convenience of the device also will suffer if every possible control function should have its own key, and these seldom used keys are the whole time available to the user.

Prior art documents that are known to disclose solutions related to this technical field include JP08-006692 A, JP04-290111, US-A-5258748 and JP02-151128. Said publications disclose e.g. solutions where the act of pressing a key produces a different character depending on the duration of time for which the key is kept pressed. The typical technical implementation of such a solution includes a programmable keypad command interpreter, which has been programmed to measure the time for which a key is held down and to map the detected length of a key pressure into a certain character.

The object of the invention is to present an electrical circuitry with the aid of which control signals can be generated with the same keys as the input signals. It is advantageous that the generating of the control signals does not affect the operation of the keys in a normal situation, and that the circuitry operates reliably. It is further advantageous that the circuitry generating the control signals does not cause changes in that original circuitry with which the input signals are generated in the normal operation of the device.

The object of the invention is attained with an electrical circuitry, which generates input signals corresponding to the keys when the keys are pressed, and where a control signal is generated by pressing in a certain sequence certain keys related to the generation of the control signal and by pressing at least some of said keys longer than a certain threshold time.

The electrical circuitry according to the invention, which comprises key members for generating input signals and two sub-circuitries, of which the first one is arranged to generate said input signals when the key members are pressed, is characterised by the features recited in the characterising part of the independent claim directed to electronic circuitry. The invention applies also to an electric device, the characteristic features of which are recited in the characterising part of the corresponding independent claim.

In the electrical circuitry according to the invention the first sub-circuitry (the basic circuitry) generates the input signals when the keys are pressed and activates a delay signal if the keys related to generating a control signal are pressed in a predetermined manner. The delay signal remains active as long as a sufficient predetermined number of keys are pressed down. The delay signal is a signal to the second sub-circuitry (the auxiliary circuitry) of the circuitry. This auxiliary circuitry comprises a delay block and a generating block. The delay block transmits a generating signal to the generating block if the delay signal received by the delay block is active longer than a certain threshold time. On the other hand, the generating block generates the actual control signal when it has received a generating signal.

The basic circuitry comprises components which are related to the transformation of pressing keys into input signals, and components which are related to the determination of whether the keys related to generating a control signal are pressed in a predefined sequence. These last mentioned components can be dimensioned so that they do not affect the generating of the actual input signals. Neither does the auxiliary circuitry generating a control signal as a result of pressing the desired keys in a certain manner have any impact on the generating of the input signals, because the current passing from the basic circuitry to the auxiliary circuitry can be dimensioned so low that it does not substantially affect the voltage levels in the basic circuitry. Thus the generating of a delay signal in the basic circuitry or the generating of a control signal in the auxiliary circuitry do not interfere with the normal use of the keys for generating input signals: pressing a key always results in the generating of corresponding input signal.

The details of the basic circuitry are determined by which keys shall be pressed and in which sequence in order to activate the delay signal, and which keys must be pressed down longer in order to keep the delay signal active. On the other hand the structure of the delay block of the auxiliary circuitry determines how long the delay signal must be active, in other words, how long said certain keys must be pressed.

If the pressing sequence of the keys is correct, but the keys or some of them are not pressed down long enough, then the delay signal is not active a sufficiently long time and the delay block does not transmit a generating signal. Then no control signal is generated.

The control signal could also be generated by only pressing certain keys one after another. If there are two ways to generate a control signal, and the same keys are related to both ways, but in the other way it is further required that at least some of the keys must be pressed down a certain minimum time, then the probability that the user unintentionally generates a control signal is greater in that way which does not apply the minimum time requirement. If the minimum time requirement is valid it is possible to use a smaller number of keys for generating a control signal. From the user's point of view a lower number of keys and pressing some of them down longer is easier to remember and handle than a greater number of keys which are pressed one after another.

If only one key is used to generate a control signal, and this is also according to the invention, then said minimum time must be chosen to be sufficiently long. If it is required that all keys related to the generating of a control signal are being pressed down simultaneously, then the minimum time must again be chosen to be sufficiently long. This is in order to prevent that a momentary simultaneous pressing of all keys could cause the generating of a control signal, for instance when the keys are pressed by the palm when the device is moved.

When the delay signal in the basic circuitry and the control signal in the auxiliary circuitry are generated without any intelligent components, then the output of the auxiliary circuitry always supplies a control signal when the keys have been pressed in a predetermined way and the operating voltages are switched on in the device. Thus a control signal can be generated with a reliably operating circuitry. If more control signals are required, then for each signal an own auxiliary circuitry is made, to which the inputs from desired keys are connected.

Below the invention is described in more detail with reference to preferred embodiments of the invention and to the enclosed figures, in which
Figure 1 shows a block diagram according to a preferred embodiment of the invention,
Figure 2 shows a block diagram according to another preferred embodiment of the invention,
Figure 3 shows the circuit diagram of a third preferred embodiment of the invention,
Figure 4 shows an auxiliary circuitry to the circuit diagram of figure 3, and
Figure 5 shows a diagram of an electrical device which utilises the circuitry according to a preferred embodiment of the invention.

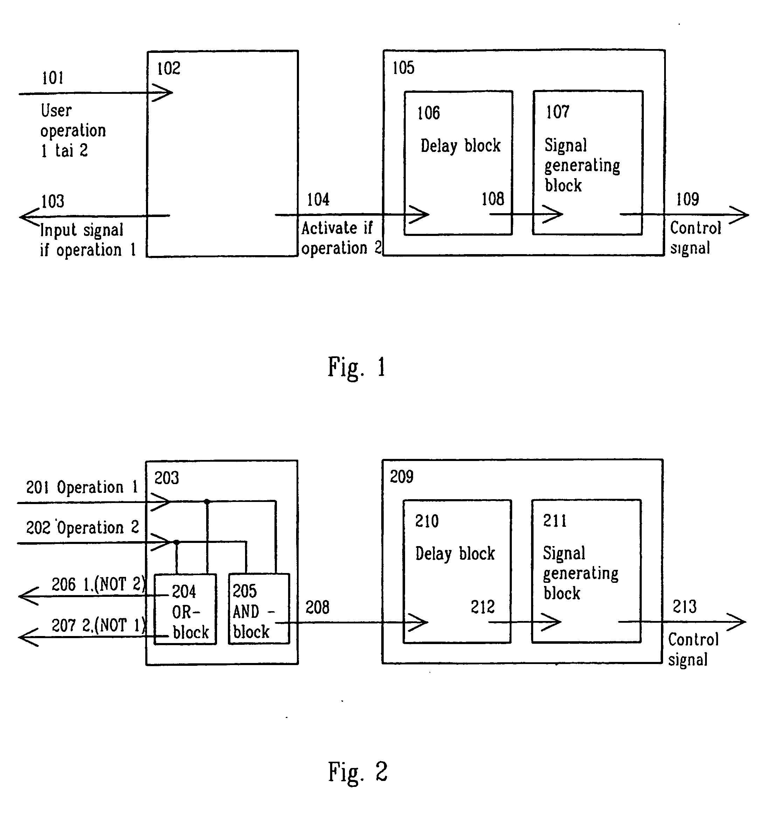

Figure 1 shows the block diagram of a preferred embodiment of the invention. In the situation presented in the figure the user is able to cause either the generation of an input signal (operation 1) or the generation of a control signal (operation 2). The operation 1 can correspond to pressing a single key, and the operation 2 may be a pressing sequence, for instance, where first three keys are pressed down, but then it is sufficient that one of them is kept down a longer time.

The user operation is represented by an arrow 101. The block 102 represents the basic circuitry which detects which operation is selected by the user, and which functions correspondingly. If the user chooses the operation 1, then the basic circuitry outputs an input signal 103. On the other hand, if the user chooses the operation 2, then the delay signal 104 is activated.

The auxiliary circuitry 105 comprises two sub-blocks, of which the delay block 106 is responsible for measuring whether the operation 2 is active longer than the defined threshold time, and the block 107 is responsible for generating the control signal. When the user chooses the operation 2 the delay signal 104 is activated. It stays activated as long as the user keeps the operation 2 chosen. If this time is longer than a certain minimum time, which is determined in the delay block, then the corresponding delay block activates the generating signal 108. When the generating signal has been activated the generating block 107 generates a control signal which is represented by the arrow 109.

If the user terminates the operation 2 before the minimum time determined in the delay block has passed, then the generating block will not get a request to generate a control signal (in other words, the generating signal is not activated). When the user has terminated the operation 2 the delay signal 104 is deactivated and the basic circuitry waits for the next operation chosen by the user. The basic circuitry can generate input signals also when the delay signal 104 is activated. The invention does not limit the function of the basic circuitry in this respect.

Figure 2 shows a block diagram of another preferred embodiment of the invention where it is defined in more detail which conditions are required for generating an input signal and a control signal. In figure 2 the arrows 201 and 202 represent user operations, for instance pressing the keys 1 and 2. The basic circuitry 203 comprises sub-blocks 204 and 205, which both have inputs from the points 201 and 202. The block 204 is related to the generating of input signals: if the user chooses the operation 1 or 2 (for instance by pressing the corresponding keys), then this block generates the corresponding input signal 206 or 207. The block's logic can be such that an input signal corresponding to the operation 1 is generated always when the user chooses the operation 1 and, similarly, an input signal corresponding to the operation 2 is generated always when the user chooses the operation 2 (logical OR). Then the additional conditions relating to the input signals 206 and 207 in figure 2 are not valid. Another alternative for the block logic is that an input signal is generated only when the user chooses either operation (logical XOR). Then the additional conditions in figure 2 are valid.

If the user has chosen both operations simultaneously, then the block 205 detects this and activates the delay signal 208 directed to the auxiliary circuitry 209. The delay signal remains activated as long as the user keeps both operations chosen. The auxiliary circuitry comprises the delay block 210 and the generating block 211, which function in the same manner as the delay and generating blocks 106 and 107 in figure 1. When the delay signal has been activated longer than the predetermined threshold time the delay block activates the generating signal 212, and as a result of the activation of said signal the generating block generates the control signal 213.

If the logic of the block 204 is XOR, then it will not generate input signals at the same time as the delay signal is active. Also, at a certain moment at most one input signal is delivered. If its logic is OR, then a simultaneous selection of the operations 1 and 2 will cause immediately two input signals and in addition a control signal, if the operations are activated for a longer time than the minimum time determined in block 210.

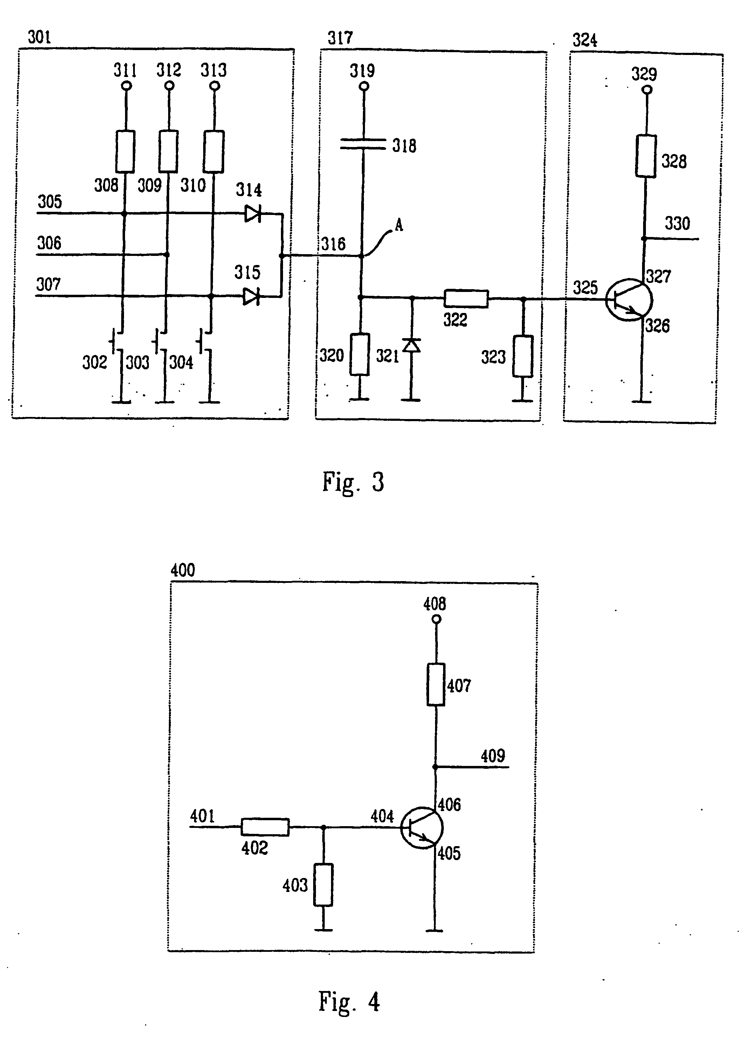

Figure 3 shows in detail the electrical circuitry of a third preferred embodiment of the invention. In this electrical circuitry the generating of a control signal requires that two keys are kept pressed down simultaneously for a sufficiently long time; the number of the keys is exemplary, and it could as well be one or more than two. The block 301 shows a circuitry with which pressing of the keys 302 to 304 is transformed into electrical input signals for the microprocessor. The inputs of the microprocessor port are taken from the points 305 to 307. As an example the keys 302 and 304 have been chosen to be said two control keys.

Let us first discuss the microprocessor input 306. It is connected via the resistor 309 to the operating voltage at the point 312, so that the resistance of the resistor 309, the operating voltage and the current taken by the microprocessor port determine the voltage in point 306 when the key 303 is open. In practice the voltage level in point 306 is close to the operating voltage when the key is open, which corresponds to a bit one in the input signal. When the user presses the key 303 it connects the point 306 to the ground potential. Thus the voltage level of the point 306 drops to zero, and the change of this voltage level represents a bit zero in the input signal.

The microprocessor inputs 305 and 307 are connected in a corresponding way via the resistors 308 and 310 to the operating voltage in the points 311 and 313, and via the keys 302 and 304 to the ground potential. The resistors 308 to 310 generally have the same resistance. Further an input 316 to the delay block 317 is taken from the points 305 and 307 via the diodes 314 and 315. At the point marked "A" the input 316 is connected to the first plate of the capacitor 318 and to the ground potential via the resistors 320 and 322, 323. The other plate of the capacitor 318 is connected to the operating voltage in the point 319. The voltage level in point A is roughly the same as in the points 305 and 307 when the keys 302 and 304 are up (assuming that the resistances of the resistors 308 to 310 are the same). In practice the diodes lower the voltage with about 0.5 volts.

Let us next discuss the function of the keys 302 and 304. The resistors 320, 322 and 323 and the current passing through them result in that when the keys are up the points 305 and 307 have a lower voltage than the point 306. The resistances 320 and 322 are dimensioned to be large compared to the resistances 308 - 310, and therefore the voltage drop is so little that it will not be interpreted as a zero bit in the input signal. When the key 302 or 304 is pressed down, then the voltage in the other of the points 305 or 307 drops to zero and this is interpreted so that the corresponding bit value changes to zero in the input signal. Thus the delay block 317 related to the control signal has no impact on the individual use of the keys. If only one key is pressed down, then that one of the points 305 or 307 which is related to the key in the up position has a voltage level which still is close to the operating voltage. This potential is sufficient to keep the voltage of the input 316 and the point A on a relatively high level, in other words, the state of the delay block 317 will not change when only one of the keys 302 or 304 is pressed.

In the following we discuss the behaviour of the delay circuitry when the keys 302 and 304 are pressed down simultaneously. The voltages of the points 305 and 307 drop to zero volt, and the value of the corresponding bits in the input signal can be interpreted as zero, depending on the microprocessor program. When the voltage drops to the ground level in the points 305 and 307 the diodes 314 and 315 are connected in the reverse direction so that no current can pass through them from the delay block to the basic circuitry. Then the potential in point A is a result of the current passing through the resistors 320, 322 and 323. The potential of point A begins to drop, and at the same time the capacitor 318 is charged: due to the combined effect of the capacitor and the resistors the voltage does not drop in one moment but with a certain time constant. Thus an activated delay signal in the circuitry shown in figure 3 corresponds to a situation where no current passes to the delay block through the input 316. The activation time of the delay signal is measured in the delay block with the aid of the voltage level decreasing with a certain time constant.

If the keys 302 and 304 are kept pressed down, and if no current passes via the input 316 to the delay circuitry, then the potential in point A continues to drop, and correspondingly the voltage behind the resistor 322, at the interface of the blocks 317 and 324 will drop. The ratio of the voltage divider resistors 322 and 323 determines the voltage level in this point compared to the voltage in point A. In the control signal generating block 324 this point is connected to the base 325 of a transistor. Finally the voltage at the base of the transistor sinks below that threshold voltage at which the transistor conducts. The current which has kept the voltage at the emitter 326 and the collector 327 close to the ground potential no longer passes through the transistor, and the voltage of the collector 327 rises due to the action of the resistor 328 and the operating voltage in point 329. The output 330 connected to the collector of the transistor will thus deliver a positive voltage pulse as a result of a simultaneous and sufficiently long pressing of the keys 302 and 304. The activation of the generating signal in the circuitry shown in figure 3 is the voltage drop below the threshold voltage at the base 325 of the transistor.

When the keys 302 and 304 are released the current will again pass through the diodes 314 and 315, which corresponds to the fact that the delay signal is deactivated. The charge stored in the capacitor 318 is discharged, and the voltage in the point A rises. Correspondingly also the voltage at the transistor base rises, and the transistor begins to conduct again. The current passing through the transistor causes the voltage at the point 330 to drop back close to the ground level. The length of the control signal is thus determined by the time the keys are pressed down.

The resistances 320 and 322 of the delay circuitry must be dimensioned to be sufficiently large compared to the key resistances 308 - 310. Particularly it must be observed that when the key 302 or 304 is up the voltage at the corresponding point 305 or 307 must be close to the operating voltage, such as the voltage in point 306 is when the key 303 is up. Otherwise the result can be one or both of the following fault situations: when only one of the keys 302 or 304 is pressed the voltage after the voltage divider resistor 322 drops so low that the transistor ceases to conduct; or when the key 302 or 304 is up the voltage in the corresponding point 305 or 307 is so close to the ground potential that it is falsely interpreted as a zero bit in the input signal.

The minimum time which the keys 302 and 304 must be pressed down for generating a control pulse is determined by the capacitance of the capacitor 318 and the resistances of the resistors 320, 322 and 323. The rate of the voltage drop at point A is determined by the combined effect of the capacitance of the capacitor and the resistances. The mutual ratio of the resistances 322 and 323 will further control how large part of the voltage at point A is transferred to the base 325 of the transistor. The higher the resistance 323 is compared to the resistance 322 the higher is the voltage at the transistor base, and the longer is the time which the keys must be pressed in order to generate a control signal. A suitable dimensioning of the components in the whole circuitry described above can be found by experiments or by simulation.

In the circuitry presented in figure 3 pressing down any of the keys 302, 303 or 304 causes always a voltage drop to zero in the corresponding point 305, 306 or 307. The keys can be used to generate input signals even when the delay signal is active, in other words when the voltage in the point A falls or has fallen so low that the circuitry outputs a control signal. Thus the circuitry shown in figure 3 corresponds to the block diagram shown in figure 2 when the logic in the block 204 is OR. The microprocessor's program can be designed so that simultaneous changes at the microprocessor ports are not accepted as an input signal, and then the whole input signal circuitry including the microprocessor represents an XOR logic.

If it is desired to use only one or more than two keys for generating a control signal, then also this is possible with the circuitry shown in figure 3. All keys which are required to be pressed down in order to generate a control signal are connected through diodes to the input 316 corresponding to the connection of the keys 302 and 304 through the diodes 314 and 315.

The charge of the capacitor 318 is discharged through the diode 321 in the circuitry when the operating voltages have been switched off.

The circuitry presented in figure 3 generates a control signal which is a voltage pulse rising from the ground potential close to the operating voltage level. Some components which are desired to be controlled with the control signal may require at their inputs a voltage pulse which falls from the operating voltage level to the ground potential. An electrical circuitry according to a fourth preferred embodiment of the invention which generates a falling control signal is provided for instance by modifying the circuitry presented in figure 3 in the following way. The points 311 to 313 and 319 of the sub-circuitries 301 and 317 are connected to the ground potential instead of the operating voltage, and the keys 302 to 304, the resistor 320 and the diode 321 which in the original circuitry are connected at one end to the ground potential are now connected to the operating voltage instead of being connected to the ground potential. Further the forward direction of the diodes 314, 315 and 321 is changed to the opposite.

The circuitry where these modifications have been made operates in a similar way as the original circuitry presented in figure 3. The following contains a short summary of the effects which the modifications have on the function of the circuitry. Pressing the keys 302 - 304 causes the voltage in the corresponding points 305 - 307 to rise to the operating voltage level. Pressing keys 302 and 304 simultaneously results in that no current passes from the delay block 317 to the block 301. Then the voltage in the modified delay block rises with a certain time constant. If the keys are pressed down simultaneously for a sufficiently long time the voltage level of the delay block reaches that threshold voltage above which the transistor in the control signal generating block will conduct. When the transistor begins to conduct the voltage level in point 330 drops from the value close to the operating voltage close to the ground potential. The release of the keys 302 and 304 results in that the voltage level drops in the modified delay block, and the transistor ceases to conduct. This causes the voltage level to rise in the point 330. Thus the control signal obtained from the modified circuitry is a falling voltage pulse.

An alternative way to generate a falling control signal is for instance the addition of the circuitry 400 shown in figure 4 to the circuitry presented in figure 3. The circuitries are combined by connecting the point 401 to the point 330. The circuitry 400 operates in the same way as the control signal generating block 324, i.e., the voltage at the transistor base 404 determines the voltage level in point 409. When the voltage at the transistor base 404 is below that threshold voltage at which the transistor conducts the voltage level at the transistor collector 406 and in the point 409 is close to the operating voltage, because the collector is connected via the resistor 407 to the operating voltage in the point 408. When the voltage at the transistor base 404 is above the threshold voltage the transistor will conduct. Then the voltage of the collector and the point 409 is close to the ground potential, because the transistor emitter 405 is connected to the ground potential.

The circuitry of figure 4 changes the rising control signal obtained from the circuitry shown in figure 3 into a falling control signal. When the voltage in the point 330 is close to the ground potential the voltage at the transistor base 404 is also close to the ground potential. The voltage divider resistors 402 and 403 ensure that the threshold voltage of the transistor is not exceeded. Thus the voltage of the point 409 is then close to the operating voltage. When the circuitry shown in the figure 3 generates a control signal the voltage in the point 330 rises close to the operating voltage. Then the voltage at the transistor base 404 rises over said threshold voltage, and the voltage level of the point 409 drops close to the ground potential. The voltage divider resistors 402 and 403 must be dimensioned so that the voltage level in point 330, which is close to the operating voltage, causes a voltage at the transistor base 404 which is higher than the threshold voltage. Thus the addition of the circuitry according to figure 4 to the circuitry shown in figure 3 provides an electrical circuitry which generates a falling control signal.

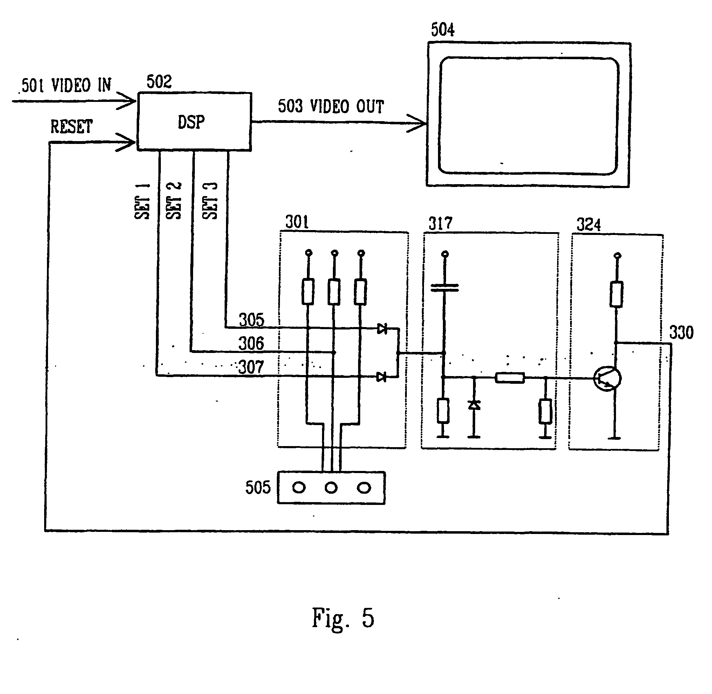

Figure 5 shows as an example the diagram of a television set or a device used for displaying a video signal which utilises the electrical circuitry according to third preferred embodiment of the invention shown in figure 3. The device comprises a display device 504 and a user interface, for example a keypad, 505 for selecting the channel to be viewed. The channels are numbered 1 to 3, and the keypad has three keys which correspond to these channels. There is no separate power switch or other control keys. Further the device comprises electronics for processing the video signal: the input video signal 501 contains all video signals corresponding to the three channels, and a digital signal processor (DSP) 502 separates from the input signal an output signal 503 corresponding to the selected channel which is then conveyed to the display device.

The electrical circuitry relating to the keypad is similar to that shown in figure 3. However, the keys are shown in a different way in figure 5: the switches related to the keys, which at one end are connected to the ground potential, are not drawn to be visible in the keypad 505. From the keys 1 and 3 an input is taken to the auxiliary circuitry, and the input signals to the digital signal processor are obtained from the outputs 305 - 307. The whole description of the electrical circuitry given in relation to the figure 3 applies also to the figure 5. In the following we discuss two operating situations: channel selection and device reset.

When the user selects a channel by pressing one of the keys in the keypad the basic circuitry 301 generates an input signal which is SET1, SET2 or SET3, depending on the key. The digital signal processor reads the input signal, and as a response to it the signal processor separates the signal corresponding to the selected channels to be the output signal 503. If the device ends up in a failure situation where it does not operate in the designed manner the user can reset the device by pressing the keys 1 and 3 simultaneously. Then the delay signal is activated and after a certain time the delay block 317 activates the generating signal. As a result of this the generating block 324 generates at its output 330 a control signal (RESET in the figure) which resets the digital signal processor. Thus the device can be reset in a failure situation with the aid of the keys used for channel selection.

Though the electrical circuitry according to the invention is divided into a basic circuitry and an auxiliary circuitry when the invention in general was described and its preferred embodiments were described above, this division is made only to facilitate the understanding of the description of the operation of the electrical circuitry according to the invention. It does not restrict which section of the electrical circuitry according to the invention contains components related to which function.

The electrical circuitry according to the invention is here described to comprise keys that the user presses down when he chooses the operation corresponding to a key. The press keys are used just as a tangible example of a user interface, and the electrical circuitry according to the invention is not limited to electrical circuitries related to press keys. The user interface may comprise, for example, buttons that are pulled or switches that are turned.

The terms referring to directions used in the description of the invention do not limit the position of the keys belonging to the user interface of an electrical device which employs an electrical circuitry according to the invention. Expression "pressing a key down" refers in general to activating the key, for example, to pulling a knob or turning a switch. In case of a press key, it refers to pressing the key nearer that surface of the electrical device where the key is attached to.

## Claims

1. An electrical circuitry for a user interface of an electrical device, which circuitry comprises
- key members for generating input signals (103), and
- two sub-circuitries, of which the first one (102) is arranged to generate said input signals when said key members are activated,
**characterised in that**
- said key members comprise certain key members for additionally generating a control signal (109) having a higher priority than the input signals,
- said first sub-circuitry (102) is arranged to generate a certain delay signal (104) when at least two of said certain key members are activated parallelly by pressing, pulling or turning, and to deactivate said delay signal when said at least two of said certain key members are not activated parallelly by pressing, pulling or turning anymore, and
- the second sub-circuitry (105) comprises a delay block (106) which is arranged to activate a certain generating signal (108), if the activation time of said delay signal exceeds a certain threshold time, and a control signal generating block (107) which is arranged to generate a control signal having a higher priority than the input signals when said generating signal is activated.

2. An electrical circuitry according to claim 1, **characterised in that** the first sub-circuitry (102) is arranged to generate the input signals related to said certain key members as an excluding alternative to the generating of said delay signal (104).

3. An electrical circuitry according to claim 1, **characterised in that** the first sub-circuitry (102) is arranged to generate said input signals always when said certain key members are activated.

4. An electrical circuitry according to claim 1, **characterised in that** the first sub-circuitry (203) is arranged to activate said delay signal (208) if all of said certain key members are activated simultaneously by pressing, pulling or turning, and to deactivate said delay signal if all of said certaion key members are not activated simultaneously by pressing, pulling or turning.

5. An electrical circuitry according to claim 4, **characterised in that** the first sub-circuitry (203) is arranged to generate the input signals related to said certain key members as an excluding alternative to the generating of said delay signal (208).

6. An electrical circuitry according to claim 4, **characterised in that** the first sub-circuitry (203) is arranged to generate the input signals always when said certain key members are activated.

7. An electrical circuitry according to claim 6, **characterised in that**
- the first part (301) of the circuitry comprises said key members (302 - 304) of which each one is at one end connected to the ground potential and at the other end through a resistor (308 - 310) to the operating voltage,
- said input signals are voltage changes at the connection points (305 - 307) of said resistors and key members,
- said certain key members are connected via rectifying components (314, 315) and a conductor (316) to said delay block (317),
- said delay signal is active when said conductor does not pass any current to said delay block,
- said delay block comprises a capacitor (318) with its first plate connected to the operating voltage, two resistors (320, 322) connected at their first ends to the second plate of said capacitor and to said conductor, whereby the second end of the first one (320) of the resistors is connected to the ground potential and the second end of the second one (322) of the resistors is connected via a third resistor (323) to the ground potential, and said capacitor and resistors are arranged so that when said delay signal is active the voltage in said delay block falls with a certain time constant,
- said control signal generating block (324) comprises a transistor with the base (325) connected to the delay block at the connection point of said second and third resistors, and with the emitter (326) connected to the ground potential and the collector (327) connected via a resistor (328) to the operating voltage,
- said generating signal is a voltage level at the base of said transistor, and it is active when the voltage is below a certain threshold voltage level defined by that threshold voltage at which the transistor conducts, and
- said control signal is the rise of the voltage level at the collector of said transistor when the generating signal connected to the transistor base is active.

8. An electrical device comprising a user interface (505) and an electrical circuit according to claim 1.

## Patentansprüche

1. Elektrische Schaltung für eine Benutzerschnittfläche, wobei die Schaltung umfasst:
- Tastenglieder zum Erzeugen von Eingabesignalen (103), und
- zwei Unterschaltungen, von denen die erste (102) so angeordnet ist, dass Eingabesignale erzeugt werden, sobald die Tastenglieder aktiviert werden
**dadurch gekennzeichnet, dass**
- die Tastenglieder bestimmte Tastenglieder zum zusätzlichen Erzeugen von Steuersignalen (109) mit einer höheren Priorität als die Eingabesignale umfassen,
- dass die erste Unterschaltung (102) so angeordnet ist, dass sie ein bestimmtes Verzögerungssignal (104) erzeugt, wenn mindestens zwei der bestimmten Tastenglieder gleichzeitig aktiviert werden durch Drücken, Ziehen oder Drehen und das Verzögerungssignal deaktiviert wird, wenn diese mindestens zwei Tastenglieder nicht gleichzeitig aktiviert werden durch nicht weiteres Drücken, Ziehen oder Drehen, und
- dass die zweite Unterschaltung (105) einen Verzögerungsblock (106) umfasst, der angeordnet ist, um ein bestimmtes Erzeugungssignal (108) zu aktivieren, wenn die Aktivierungszeit des Verzögerungssignals einen bestimmten Schwellenwert überschreitet, wobei sie ferner einen Steuersignal-Erzeugungsblock (107) umfasst, der so angeordnet ist, dass er ein Steuersignal mit höherer Priorität als die Eingabesignale erzeugt, wenn das Erzeugungssignal aktiviert worden ist.

2. Elektrische Schaltung nach Anspruch 1, **dadurch gekennzeichnet, dass** die erste Unterschaltung (102) so angeordnet ist, dass sie die Eingabesignale in Bezug auf bestimmte Tastenglieder als ausschließende Alternative zur Erzeugung des Verzögerungssignals (104) ist.

3. Elektrische Schaltung nach Anspruch 1, **dadurch gekennzeichnet, dass** die erste Unterschaltung (102) so angeordnet ist, dass die Eingabesignale immer dann erzeugt werden, wenn bestimmte Tastenglieder aktiviert werden.

4. Elektrische Schaltung nach Anspruch 1, **dadurch gekennzeichnet, dass** die erste Unterschaltung (203) so angeordnet ist, dass das Verzögerungssignal (208) erzeugt wird, wenn alle bestimmten Tastenglieder gleichzeitig aktiviert werden durch Drücken, Ziehen oder Drehen, und um das Verzögerungssignal zu deaktivieren, wenn alle der genannten bestimmten Tastenglieder nicht gleichzeitig durch Drücken, Ziehen oder Drehen aktiviert werden.

5. Elektrische Schaltung nach Anspruch 4, **dadurch gekennzeichnet, dass** die erste Unterschaltung (203) so angeordnet wird, dass Eingabesignale in Bezug auf bestimmte Tastenglieder als ausschließende Alternative zum Erzeugen des Verzögerungssignals (208) erzeugt werden.

6. Elektrische Schaltung nach Anspruch 4, **dadurch gekennzeichnet, dass** die erste Unterschaltung (203) so angeordnet ist, dass Eingabesignale immer dann erzeugt werden, wenn die bestimmten Tastenglieder aktiviert werden.

7. Elektrische Schaltung nach Anspruch 6, **dadurch gekennzeichnet, dass**
- der erste Teil (301) der Schaltung die Tastenglieder (302-304), von denen jedes an einem Ende mit einem Grundpotential und am anderen Ende mit einem elektrischen Widerstand (308-310) mit der Betriebsspannung verbunden ist,
- dass die bestimmten Tastenglieder mittels Ausrichtungskomponenten (314, 315) und einem Leiter (316) mit dem Verzögerungsblock (317) verbunden sind,
- dass das Verzögerungssignal aktiv ist, wenn der Leiter keinerlei Strom in den Verzögerungsblock leitet,
- dass das Verzögerungssignal einen Kondensator (318) umfasst, wobei dessen erste Platte mit der Betriebsspannung verbunden ist, zwei elektrische Widerstände (320, 322) an ihren ersten Enden mit der zweiten Platte des Kondensators und dem Leiter verbunden sind, wobei das zweite Ende des ersten (320) elektrischen Widerstands mit dem Grundpotential verbunden ist und das zweite Ende des zweiten (322) elektrischen Widerstandes mittels eines dritten Widerstandes (323) mit dem Grundpotential verbunden ist, und dass der Kondensator und die Widerstände so angeordnet werden, dass, wenn das Verzögerungssignal aktiv ist, die Spannung in dem Verzögerungsblock mit einer bestimmten Zeitkonstante abfällt,
- dass der Steuersignal erzeugende Block (324) einen Transistor umfasst, wobei dessen Basis (325) mit dem Verzögerungsblock an der Verbindungsstelle von dem zweiten und dritten elektrischen Widerstand verbunden ist, wobei der Emitter (326) mit dem Grundpotential und dem Stromabnehmer (327) verbunden ist, der mittels des Widerstandes (328) mit der Betriebsspannung verbunden ist,
- dass das Erzeugungssignal ein Spannungswert an der Basis des Transistors ist und aktiv ist, wenn die Spannung unter einem bestimmten Schwellenspannungswert lieg, der durch die Schwellenspannung, bei der der Transistor in Betrieb genommen wird, festgelegt ist, und
- dass das Steuersignal der Anstieg des Spannungswertes am Stromabnehmer des Transistors ist, wenn das erzeugte Signal, das mit der Transistorbasis verbunden ist, aktiv ist.

8. Elektrische Vorrichtung umfassend eine Benutzerschnittstelle (505) und eine elektrische Schaltung nach Anspruch 1.

## Revendications

1. Ensemble de circuits électriques destiné à une interface d'utilisateur d'un dispositif électrique, lequel ensemble de circuits comprend
- des éléments de touches destinés à générer des signaux d'entrée (103), et
- deux sous-ensembles de circuits, dont le premier (102) est conçu pour générer lesdits signaux d'entrée lorsque lesdits éléments de touches sont actionnés,
**caractérisé en ce que**
- lesdits éléments de touches comprennent certains éléments de touches destinés à générer en plus un signal de commande (109) ayant un niveau de priorité supérieur à celui des signaux d'entrée,
- ledit premier sous-ensemble de circuits (102) est conçu pour générer un certain signal de retard (104) lorsque au moins deux desdits certains éléments de touches sont actionnés en parallèle par pression, tirage ou rotation, et pour désactiver ledit signal de retard lorsque lesdits au moins deux desdits certains éléments de touches ne sont plus actionnés en parallèle par pression, tirage ou rotation, et
- le second sous-ensemble de circuits (105) comprend un bloc à retard (106) qui est conçu pour activer un certain signal de génération (108), si le temps d'activation dudit signal de retard dépasse un certain temps de seuil, et un bloc de génération de signal de commande (107) qui est conçu pour générer un signal de commande ayant un niveau de priorité supérieur à celui des signaux d'entrée lorsque ledit signal de génération est activé.

2. Ensemble de circuits électriques selon la revendication 1, **caractérisé en ce que** le premier sous-ensemble de circuits (102) est conçu pour générer des signaux d'entrée associés auxdits certains éléments de touches en tant qu'alternative exclusive à la génération dudit signal de retard (104).

3. Ensemble de circuits électriques selon la revendication 1, **caractérisé en ce que** le premier sous-ensemble de circuits (102) est conçu pour générer lesdits signaux d'entrée à chaque fois que lesdits certains éléments de touches sont actionnés.

4. Ensemble de circuits électriques selon la revendication 1, **caractérisé en ce que** le premier sous-ensemble de circuits (203) est conçu pour activer ledit signal de retard (208) si la totalité desdits certains éléments de touches sont actionnés simultanément par pression, tirage ou rotation, et pour désactiver ledit signal de retard si la totalité desdits certains éléments de touches ne sont pas actionnés simultanément par pression, tirage ou rotation.

5. Ensemble de circuits électriques selon la revendication 4, **caractérisé en ce que** le premier sous-ensemble de circuits (203) est conçu pour générer les signaux d'entrée associés auxdits certains éléments de touches en tant qu'alternative exclusive à la génération dudit signal de retard (208).

6. Ensemble de circuits électriques selon la revendication 4, **caractérisé en ce que** le premier sous-ensemble de circuits (203) est conçu pour générer les signaux d'entrée à chaque fois que lesdits certains éléments de touches sont actionnés.

7. Ensemble de circuits électriques selon la revendication 6, **caractérisé en ce que**
- la première partie (301) de l'ensemble de circuits comprend lesdits éléments de touches (302 à 304) dont chacun est à une première extrémité relié au potentiel de masse et à l'autre extrémité, par l'intermédiaire d'une résistance (308 à 310) relié à la tension de fonctionnement,
- lesdits signaux d'entrée représentent des variations de tension au niveau des points de connexion (305 à 307) desdites résistances et desdits éléments de touches,
- lesdits certains éléments de touches sont reliés par l'intermédiaire de composants de redressement (314, 315) et d'un conducteur (316) audit bloc à retard (317),
- ledit signal de retard est actif lorsque ledit conducteur ne laisse passer aucun courant vers ledit bloc à retard,
- ledit bloc à retard comprend un condensateur (318) dont la première électrode est reliée à la tension de fonctionnement, deux résistances (320, 322) reliées à leurs premières extrémités à la seconde électrode dudit condensateur et audit conducteur, grâce à quoi la seconde extrémité de la première (320) des résistances est reliée au potentiel de masse et la seconde extrémité de la deuxième (322) des résistances est reliée par l'intermédiaire d'une troisième résistance (323) au potentiel de masse, et ledit condensateur ainsi que lesdites résistances sont agencées de sorte que lorsque ledit signal de retard est actif, la tension dans ledit bloc à retard chute avec une certaine constante de temps,
- ledit bloc de génération de signal de commande (324) comprend un transistor dont la base (325) est reliée au bloc à retard au niveau du point de connexion desdites seconde et troisième résistances, et dont l'émetteur (326) est relié au potentiel de masse et le collecteur (327) est relié par l'intermédiaire d'une résistance (328) à la tension de fonctionnement,
- ledit signal de génération est un niveau de tension au niveau de la base dudit transistor, et il est actif lorsque la tension est inférieure à un certain niveau de tension de seuil défini par la tension de seuil à laquelle le transistor devient conducteur, et
- ledit signal de commande est l'augmentation du niveau de tension du collecteur dudit transistor lorsque le signal de génération relié à la base du transistor est actif.

8. Dispositif électrique comprenant une interface d'utilisateur (505) et un circuit électrique selon la revendication 1.
